# EUROPÄISCHE PATENTSCHRIFT

(11) **EP 4 140 264 B1**
(45) Veröffentlichungstag und Bekanntmachung des Hinweises auf die Patenterteilung: **29.07.2026**
(21) Anmeldenummer: 21725706.2
(22) Anmeldetag: 20.04.2021
(51) Int. Cl.: H05K 7/14

(54) **ELEKTRISCHES FELDGERÄT**
ELECTRIC FIELD DEVICE
APPAREIL À CHAMP ÉLECTRIQUE

(30) Priorität: 20.04.2020 DE 202020102186 U
(43) Veröffentlichungstag der Anmeldung: 01.03.2023
(73) Patentinhaber: Samson Aktiengesellschaft, 60314 Frankfurt (DE)
(72) Erfinder: RAUSCH, Sven, 61130 Nidderau (DE); SCHULZ, Nikolai, 64859 Eppertshausen (DE); BODE, Christopher, 65760 Eschborn (DE)
(74) Vertreter: patcare Patentanwälte Partnerschaft mbB
(86) Internationale Anmeldenummer: PCT/EP2021/060276
(87) Internationale Veröffentlichungsnummer: WO 2021/214084

(56) Entgegenhaltungen:
- EP-A2- 0 866 532
- DE-A1- 102014 106 540

## Beschreibung

Die Erfindung betrifft ein elektrisches Feldgerät gemäß der im Oberbegriff des Anspruches 1 angegebenen Art und ein Prozessventil mit einem solchen Feldgerät gemäß Anspruch 15.

Bei Prozessen in der chemischen und petrochemischen Industrie ist die Bildung einer explosionsfähigen Atmosphäre in der Regel nicht auszuschließen. In diesem Fall müssen die eingesetzten Anlagenkomponenten, z. B. elektrische Feldgeräte wie Stellungsregler, speziellen Anforderungen bezüglich des Explosionsschutzes gerecht werden. Bei der Zündschutzart der druckfesten Kapselung "Ex d" beruht die Funktionsweise auf dem Einschluss einer im Gehäuseinneren eventuell auftretenden Explosion, so dass eine Übertragung der Explosion auf die das Gehäuse umgebende Atmosphäre verhindert wird. Erreicht wird dieses durch eine explosionsdruckfeste Auslegung des Gehäuses zusammen mit zünddurchschlagsicheren Spalten an allen Gehäuseöffnungen, wobei die elektrischen Komponenten, die eine explosionsfähige Atmosphäre zünden können, im Gehäuse eingeschlossen sind. Die Anforderungen an ein Betriebsmittel der Zündschutzart der druckfesten Kapselung sind in der Norm EN 60079-1 beschrieben.

In der EP 0 866 532 A2 ist ein Gehäuse für eine elektrische Schaltung zum Einsatz in explosionsgefährdeten Bereichen beschrieben. Das Gehäuse ist durch eine Zwischenwand in einen Elektronikraum und einen Klemmraum unterteilt. Der Elektronikraum und der Klemmraum weisen jeweils ein lösbares dichtes Abdeckelement auf. Der Zwischenwand ist eine druckfeste elektrische Durchführung zugeordnet, die auf der Seite des Elektronikraums elektrisch leitend mit Elektronikplatinen verbunden ist. Auf der Seite des Klemmraums besteht eine elektrische Verbindung zu den Anschlussklemmen und einem Anschlusselement für eine Bedieneinheit, die entweder in einer Entfernung zum Aufstellungsort des Gehäuses oder direkt am Gehäuse angeordnet ist, wobei sie gegenüber dem Gehäuse drehbar ist.

Die DE 198 10 350 A1 beschreibt ein elektrisches Feldgerät der Zündschutzart der druckfesten Kapselung, das aus mindestens zwei mechanisch sowie elektrisch gekoppelten Modulen gebildet ist. Ein erstes Modul weist einen Anschlussraum zum Anschluss des Feldgerätes in einem explosionsgefährdeten Bereich mit darin angeordneter Sicherheitsbarriere und ein Gehäuse der Zündschutzart der druckfesten Kapselung auf. Ein zweites Modul, das Eigenschaften eines Feldgeräts der eigensicheren Zündschutzart aufweist, kann auch im explosionsgefährdeten Bereich zu Einstell- und Wartungszwecken geöffnet werden. Die elektrische Verbindung zwischen den beiden Modulen umfasst eine zünddurchschlagsichere Aderleitungsdurchführung, und die elektrischen Signalverbindungen des zweiten Moduls sind über die Aderleitungsdurchführung realisiert.

In der EP 2 016 318 B1 ist ein Prozessventil beschrieben, das eine modular strukturierte Gehäuseaggregation für eine Kontrollelektronik aufweist, d. h. für eine Überwachungs-, Steuerungs- und/oder Regelelektronik. Die Gehäuseaggregation ist entsprechend den Anforderungen des Prozessventils wahlweise aus einem vorgegebenen begrenzten Vorrat an Modulen in Verbindung mit einem Abdeckelement, das zwei unterschiedliche Ausführungsformen aufweist, zusammengesetzt. Die jeweiligen Abdeckelemente sind mit einer Bedieneinheit ausgebildet, die ein Anzeige- und Bedienelement aufweist, und nehmen die gesamte Kontrollelektronik auf, wobei die Kontrollelektronik entsprechend den Anforderungen des Prozessventils mit unterschiedlichen Platinen ausgebildet ist. Sämtliche Module und das jeweilige Abdeckelement sind über identische Verbindungsstellen miteinander verbindbar. Die Gehäuseaggregation ist unter Zwischenschaltung eines Adapterteils mit einem Antriebsgehäuse des Prozessventils verbunden. Im Adapterteil ist ein Halterungsring angeordnet, welcher der Gehäuseaggregation gegenüber dem Antriebsgehäuse eine Drehbarkeit ermöglicht.

Ein weiteres Feldgerät wird in der DE102014106540A1 gezeigt.

Der Erfindung liegt die Aufgabe zu Grunde, ein elektrisches Feldgerät der im Oberbegriff des Patentanspruches 1 beschriebenen Art derart weiterzubilden, dass das Feldgerät unter Berücksichtigung von guter Zugänglichkeit, Ablesbarkeit und Bedienung sowie einfachen Zuführbedingungen an unterschiedliche Platzverhältnisse einer Prozessanlage auf einfache Weise anpassbar ist.

In bekannter Art und Weise umfasst ein elektrisches Feldgerät der Zündschutzart der druckfesten Kapselung zum Einsatz in explosionsgefährdeten Bereichen, das zur Steuerung und/oder Regelung einer Ventileinheit einer prozesstechnischen Anlage dient, ein Gehäuse, in dem eine elektronische Bauteile umfassende Kontrolleinheit angeordnet ist, die als Überwachungs-, Steuerungs- und/oder Regeleinheit dient. Die Bauart des explosionsdruckfesten Gehäuses ist nach Norm EN 60079-1 ausgeführt, wobei es mit Dichtungen versehen ist und zünddurchschlagsichere Spalte an allen Gehäuseöffnungen aufweist, sodass eine druckdichte Kapselung der elektronischen Bauteile gewährleistet ist, wodurch eine mögliche Explosion im Inneren des Gehäuses keinen Einfluss auf die umgebende explosionsfähige Atmosphäre hat.

Die Kontrolleinheit weist eine lösbare Kommunikationsverbindung zu einer Bedieneinheit auf. Die Kontrolleinheit steht in Wirkverbindung mit der Bedieneinheit, die beispielsweise im Gehäuse integriert sein kann und insbesondere ein Display-, Anzeige- und/oder Bedienelement umfassen kann.

Das Gehäuse ist über eine mechanische Schnittstelle mit einem Antriebsgehäuse der Ventileinheit verbunden. Die Verbindung kann beispielsweise über eine Verschraubung erfolgen.

Das Gehäuse weist Anschlussdurchführungen auf, über die Leitungen angeschlossen sind. Die Anschlussdurchführungen sind bevorzugt in Form von Kabelverschraubungen ausgebildet. Die Leitungen sind über eine Verbindungsschnittstelle mit der Kontrolleinheit verbunden. Dazu kann die Verbindungsschnittstelle beispielsweise mit Anschlussklemmen ausgebildet sein. Die Anschlussklemmen können beispielsweise in der Kontrolleinheit integriert sein, oder sie können von der Kontrolleinheit getrennt angeordnet sein.

Erfindungsgemäß ist das Gehäuse als eine modular strukturierte Gehäuseaggregation ausgebildet. Die modulare Struktur ermöglicht eine wahlweise Kombination einzelner Gehäusebauteile zur individuellen Anpassung an die Anforderungen des Prozessventils.

Die modulare Gehäuseaggregation weist ein erstes Modul auf, das mit der mechanischen Schnittstelle zur Verbindung mit einem Antriebsgehäuse ausgebildet ist. Bevorzugt weist die mechanische Schnittstelle des ersten Moduls beispielsweise Bohrungen auf, über die es mit dem Antriebsgehäuse insbesondere verschraubt sein kann. Die unmittelbare Positionierung des elektrischen Feldgeräts am Antriebsgehäuse ermöglicht, dass die Kontrolleinheit des elektrischen Feldgeräts auf einfache Art und Weise elektrisch sowie pneumatisch mit dem Antrieb verbindbar ist, so dass die Positionierung und/oder Regelung des Stellgliedes der Ventileinheit über die Kontrolleinheit erfolgen kann.

Das erste Modul ist mit Anschlussdurchführungen ausgebildet. Wenn die Anschlussdurchführungen in der Art einer Kabelverschraubung ausgeführt sind, können die Leitungen, insbesondere Kabel, durch die Kabelverschraubung ins Innere des Moduls geführt sein. Wenn die Anschlussdurchführung in Form von Steckanschlüssen ausgebildet ist, können die Leitungen daran angeschlossen sein. Die Leitungen sind über die Verbindungsschnittstelle mit der Kontrolleinheit verbunden.

Die Kontrolleinheit ist im ersten Modul befestigt und ist lagefest gegenüber dem ersten Modul eingebaut. Über die Kontrolleinheit ist eine bidirektionale Kommunikation mit dem elektrischen Feldgerät möglich. Das ist einerseits über die elektrisch mit der Kontrolleinheit verbindbare Bedieneinheit möglich. Die Kontrolleinheit weist auch ein Interface zu einer Leitstelle auf, wodurch die Kontrolleinheit alternativ aus einer Entfernung zum Aufstellungsort des Gehäuses überwachbar und/oder bedienbar sein kann. Die Kommunikation zwischen der Leitstelle und der Kontrolleinheit kann z. B. über ein BUS-System erfolgen. Diese Anordnung ist insbesondere von Vorteil bei Anlagen, die schlecht zugänglich sind, besonders rauen Umweltbedingungen ausgesetzt sind oder eine erhöhte Vibrationsbelastung aufweisen.

Das erste Modul ist wahlweise unmittelbar und mittelbar mechanisch mit einem Abdeckelement lösbar verbindbar. Die direkte Verbindung des ersten Moduls mit dem Abdeckelement weist eine Gehäuseaggregation mit einer kurzen Baulänge auf. In vorteilhafter Weise weist die Gehäuseaggregation in dieser Konfiguration ein geringes Gewicht sowie eine geringe Größe auf. Insbesondere weist das Gehäuse eine geringe axiale Erstreckung auf, so dass es einfach an eine prozesstechnische Anlage anpassbar ist, bei der nur ein geringer Bauraum für das elektrische Feldgerät zur Verfügung steht.

Die mittelbare Verbindung des ersten Moduls mit dem Abdeckelement erfolgt unter Zwischenschaltung eines zweiten Moduls. Die modulare Struktur der Gehäuseaggregation ermöglicht unterschiedlich zusammengestellte Konfigurationen des Gehäuses unter Verwendung eines einheitlichen Abdeckelements sowie eines einheitlichen ersten Moduls. So ist in einer alternativen Gehäuseaggregation das erste Modul mit dem zweiten Modul verbunden, das wiederum mit dem Abdeckelement verbunden ist. Durch die Verwendung eines einheitlichen Abdeckelements sowie eines einheitlichen ersten Moduls, die als Grundkörper für die unterschiedlichen Gehäuseaggregationen dienen, weist die modulare Struktur eine vereinfachte Anordnung mit einer geringen Anzahl von Gehäusebauteilen auf.

Im zweiten Modul ist die Bedieneinheit lagefest angeordnet. Das zweite Modul ist zur Aufnahme der Bedieneinheit ausgebildet. Dabei kann das zweite Modul insbesondere eine Aussparung aufweisen, in der die Bedieneinheit beispielsweise hinter einem druckfesten Sichtfenster angeordnet ist.

Ferner kann das zweite Modul eine Vielzahl von Anschlussdurchführungen aufweisen. Die Anschlussdurchführungen können in Umfangsrichtung des zweiten Moduls an mehreren Positionen ausgebildet sein. An die Anschlussdurchführungen sind Leitungen anschließbar, die über die Verbindungsschnittstelle, die insbesondere Anschlussklemmen aufweisen kann, mit der Kontrolleinheit elektrisch verbunden sind.

Das zweite Modul ist gegenüber dem ersten Modul in unterschiedlichen Winkelausrichtungen um eine Längsachse des elektrischen Feldgeräts am ersten Modul fixierbar. Die Längsachse des elektrischen Feldgeräts erstreckt sich orthogonal zur Verbindungsebene des ersten und zweiten Moduls.

Das erste Modul ist über die mechanische Schnittstelle in einer festen Lage am Antriebsgehäuse fixiert. Demnach ist das zweite Modul gegenüber dem ersten Modul sowie gegenüber dem Antriebsgehäuse in unterschiedlichen Winkelausrichtungen am Antriebsgehäuse der Ventileinheit fixierbar. Dadurch sind die Positionen der jeweiligen Anschlussdurchführungen und der Bedieneinheit, die jeweils lagefest gegenüber dem zweiten Modul angeordnet sind, über die unterschiedlichen Winkelausrichtungen des zweiten Moduls optimal an die Bauraumverhältnisse der prozesstechnischen Anlage anpassbar. So lässt sich die Position der Bedieneinheit leicht an die Bauraumverhältnisse der Anlage anpassen, um eine gute Zugänglichkeit, einfache Ablesbarkeit und leichte Bedienung zu sichern. Ähnlich verhält es sich mit der Position der Anschlussdurchführungen, über welche die Zuführbedingungen der elektrischen Leitungen leicht an die Anbauverhältnisse der Anlage anpassbar sind.

Die Kontrolleinheit weist eine Platine auf und die Bedieneinheit umfasst ein Trägerelement, an dem ein Display-, Anzeige- und/oder Bedienelement angeordnet sind. Das Trägerelement der Bedieneinheit kann beispielsweise als eine Leiterplatte oder eine Platine ausgebildet sein, die der mechanischen Befestigung sowie elektrischen Verbindung einzelner elektronischer Elemente der Bedieneinheit, z. B. des Display-, Anzeige- und/oder Bedienelements, dient.

Die Bedieneinheit ist lagefest im zweiten Modul angeordnet und kann über das Display-, Anzeige- und / oder Bedienelement zur bidirektionalen Kommunikation des elektrischen Feldgeräts dienen. Die lagefeste Anordnung gegenüber dem zweiten Modul kann beispielsweise über eine Verschraubung des Trägerelements mit dem zweiten Modul erfolgen.

Ein vom Trägerelement getragenes Bedienelement, beispielsweise eine Bedienschraube, kann das zweite Modul insbesondere über eine Ausnehmung durchsetzen, um z. B. eine Bedienung des elektrischen Feldgeräts von außen am Gehäuse zu ermöglichen.

Das Display- und/oder Anzeigeelement kann insbesondere lagefest in einer Aussparung des zweiten Moduls angeordnet sein. Dabei kann die Aussparung beispielsweise von einem druckfest mit dem zweiten Modul verbundenen Sichtfenster, z. B. einer Glasscheibe, abgedeckt sein.

Erfindungsgemäß erfolgt die lösbare Kommunikationsverbindung zwischen der Kontrolleinheit und der Bedieneinheit t über ein Anschlusselement, über welches das Trägerelement flexibel zur Platine anordenbar ist. Das Trägerelement, an dem das Display-, Anzeige- und/oder Bedienelement befestigt sind, weist eine lagefeste Anordnung gegenüber dem zweiten Modul auf. Das Trägerelement ist über das Anschlusselement flexibel mit der Kontrolleinheit, die lagefest im ersten Modul befestigt ist, verbunden. Die Flexibilität der Verbindung zwischen dem Trägerelement und der Platine über das Anschlusselement ermöglicht, dass die Bedieneinheit einfach an die Winkelausrichtung des zweiten Moduls gegenüber dem ersten Modul anpassbar ist. Mit anderen Worten ist das Trägerelement sowie die gesamte Bedieneinheit über das Anschlusselement flexibel an eine Rotation des zweiten Moduls um die Längsachse des Gehäuseaggregats anpassbar, sodass die lagefeste Anordnung der Bedieneinheit gegenüber dem zweiten Modul gewährleistet ist.

Gemäß einer bevorzugten Ausführungsform ist die Platine elektrisch leitend mit der Verbindungsschnittstelle verbunden, wobei die Verbindungsschnittstelle Anschlussklemmen aufweisen kann, die räumlich von der Kontrolleinheit getrennt sein können. So können die Anschlussklemmen der Verbindungsschnittstelle im zweiten Modul, das entfernt zum ersten Modul liegt, in dem die Kontrolleinheit befestigt ist, angeordnet sein. Über die getrennte Anordnung der Verbindungsschnittstelle gegenüber der Kontrolleinheit können die Platzverhältnisse im Gehäuse geschickt genutzt werden. So kann die Verbindungsschnittstelle direkt im ersten Modul angeordnet sein, wodurch das erste Modul in vorteilhafter Weise eine kompakte Baulänge aufweisen kann.

Bevorzugt ist das Anschlusselement als ein Steckverbinder auf der Platine der Kontrolleinheit ausgebildet, wobei die Platine eine Vielzahl von Steckverbindern an verschiedenen Positionen aufweist.

Die Position des Trägerelements an der Platine der Kontrolleinheit ist über ein Umstecken an den Steckverbindern veränderbar, wobei das Umstecken des Trägerelements derart erfolgt, dass die lagefeste Anordnung des Trägerelements gegenüber dem zweiten Modul bei einer Veränderung der Winkelausrichtung des zweiten Moduls gegenüber dem ersten Modul gewährleistet ist. Dazu reflektiert die Platine über die Anordnung der Steckverbinder die Symmetrieanforderungen des zweiten Moduls, sodass die Positionen des Display- und/oder Anzeigeelements sowie des Bedienelements, die am Trägerelement angeordnet sind, jeweils an die Positionen der Aussparung und der Ausnehmung des zweiten Moduls anpassbar sind. Über das flexible Umstecken an unterschiedlich positionierte Steckverbinder der Platine der Kontrolleinheit ist das Trägerelement der Bedieneinheit an die Winkelausrichtung des zweiten Moduls gegenüber dem ersten Modul anpassbar.

In einer alternativen Ausführungsform ist das Trägerelement mittels einer Kabelverbindung mit der Platine verbunden. Die flexible Kabelverbindung ermöglicht eine Rotation des Trägerelements um einen großen Winkelbereich, insbesondere von mehr als 180°, sodass sich insbesondere auch ein Winkelbereich von bis zu 360° gegenüber der Platine der Kontrolleinheit ergibt. In dieser Ausführungsform kann das Trägerelement insbesondere mit dem zweiten Modul lösbar verbunden, z. B. verschraubt, sein. Das Trägerelement ist gegenüber dem zweiten Modul in einer gleichbleibenden Position angeordnet. So ist die Position des Trägerelements, mit dem das Display-, Anzeige- und/oder Bedienelement mechanisch verbunden ist, ausschließlich über die Winkelausrichtung des zweiten Moduls gegenüber dem ersten Modul veränderbar.

Gemäß einer bevorzugten Ausführungsform weisen das erste Modul, das zweite Modul und das Abdeckelement jeweils einen Anschlussbereich auf, über welchen sie jeweils mechanisch miteinander verbindbar sind. Die jeweiligen Anschlussbereiche sind einheitlich festgelegt, so dass das erste Modul wahlweise mit dem zweiten Modul und mit dem Abdeckelement verbindbar ist. In den jeweiligen Anschlussbereichen sind das erste Modul, das zweite Modul und das Abdeckelement auf identische Weise zueinander zentriert und miteinander verbindbar.

Vorzugsweise weisen die jeweiligen Anschlussbereiche einen rotationssymmetrischen zylinderförmigen Übergang auf, wobei die jeweiligen Übergänge derart ineinandergreifen, dass sie jeweils axial anliegende Flächen aufweisen. So kann beispielsweise der Übergang des Abdeckelements in den Übergang des ersten Moduls und/oder des zweiten Moduls eingreifen, wobei der Übergang des jeweils ersten oder zweiten Moduls den Übergang des Abdeckelements radial umgreift. Auf gleiche Art und Weise kann der Übergang des zweiten Moduls in den Übergang des ersten Moduls eingreifen. Die jeweils ineinandergreifenden Übergänge sind rotationssymmetrisch und zylinderförmig ausgebildet und weisen im zusammengebauten Zustand der Gehäuseaggregation axial anliegende Flächen auf.

Gemäß einer bevorzugten Ausführungsform sind die jeweiligen Anschlussbereiche über eine formschlüssige und/oder kraftschlüssige Verbindung miteinander verbindbar. Auf diese Weise kann die Verbindung durch die geometrische Berührung von zwei Wirkflächen der jeweiligen Anschlussbereiche erfolgen und/oder die Verbindung ist durch ein System reibbedingter Kräfte verursacht.

Bevorzugt erfolgt die Verbindung in axialer Richtung über eine Verschraubung einer Lochpaarung der jeweiligen Anschlussbereiche. Die jeweiligen Anschlussbereiche können insbesondere über einen Flansch lösbar miteinander verbunden sein, wobei eine Schraubverbindung einen Anpressdruck auf den Flansch aufbringt. Ein jeweiliger Anschlussbereich kann beispielsweise ein Flanschblatt mit Bohrungen, die ein Lochmuster ausbilden, aufweisen. Über eine Lochpaarung der Lochmuster der jeweiligen Flanschblätter sind die miteinander zu verbindenden Gehäuseteile zueinander zentriert positionierbar. Dabei ist die Winkelausrichtung des zweiten Moduls gegenüber dem ersten Modul von der Enge des Rasters der jeweiligen Lochmuster abhängig.

Gemäß einer besonders bevorzugten Ausführungsform ist der Anschlussbereich des zweiten Moduls gegenüber dem Anschlussbereich des ersten Moduls stufenlos justierbar. Die jeweiligen Anschlussbereiche des ersten Moduls und des zweiten Moduls können beispielsweise mit einem Außengewinde ausgebildet sein, das mit dem Innengewinde eines beweglichen Gewindestücks verschraubbar ist, wobei das bewegliche Gewindestück beispielsweise als eine Überwurfmutter ausgebildet ist. Die Überwurfmutter kann beispielsweise die jeweiligen Anschlussbereiche des ersten und zweiten Moduls radial umgreifen, wobei sie z. B. über einen am Gehäuse ausgebildeten Absatz am Gehäuse fixierbar ist. Auf diese Weise ist die Winkelausrichtung des zweiten Moduls gegenüber dem ersten Modul um die Längsachse des elektrischen Feldgeräts in vorteilhafter Weise stufenlos anpassbar, sodass die am zweiten Modul ausgebildete Bedieneinheit sowie Anschlussdurchführungen eine optimal an die Bauraumverhältnisse der Anlage angepasste Position einnehmen können.

Bevorzugt weist der Anschlussbereich des zweiten Moduls ein Langlochmuster auf. Die jeweiligen Anschlussbereiche des ersten und des zweiten Moduls können insbesondere über einen Flansch lösbar miteinander verbunden sein, wobei der Anschlussbereich des zweiten Moduls ein Flanschblatt aufweist, das mit einem Langlochmuster ausgebildet ist. Auf diese Weise ist die Winkelausrichtung des zweiten Moduls gegenüber dem ersten Modul stufenlos anpassbar.

Vorzugsweise weist das erste Modul gegenüber dem zweiten Modul einen Drehanschlag auf. Ein mechanischer Anschlag begrenzt die Winkelausrichtung des zweiten Moduls gegenüber dem ersten Modul. So ist eine Winkelveränderung des zweiten Moduls gegenüber dem ersten Modul von nahezu 360° möglich. Das verhindert insbesondere eine Beeinträchtigung der Kabelverbindung zwischen der Kontrolleinheit und der Bedieneinheit durch Überdrehen.

Gemäß einer Ausführungsform ist im ersten Modul eine Positionserkennungssensorik für eine Lagemessung einer Ventilgliedstellung angeordnet. Bei der Positionserkennungssensorik kann es sich um einen Magneten handeln, dessen Feldstärke oder Feldlinienrichtung positionsabhängig von einem magnetempfindlichen Sensor ausgelesen wird. Dabei können der Magnet beispielsweise außerhalb des Gehäuses des Stellungsreglers und der magnetempfindliche Sensor innerhalb des Stellungsreglers positioniert sein, zur Ermittlung einer jeweiligen Stellung einer Ventilstange. Die Positionserkennungssensorik ist im ersten Modul integriert, das als ein Grundkörper für die unterschiedlichen Konfigurationen der Gehäuseaggregationen dient und unmittelbar benachbart zum Antriebsgehäuse angeordnet ist.

Bevorzugt ist im ersten Modul ein IP-Wandler angeordnet. Der IP-Wandler ist mit der Kontrolleinheit, die zur Überwachung, Steuerung und/oder Regelung der Ventileinheit dient, elektrisch verbunden. Er dient zum Ansteuern des pneumatischen Antriebs des Stellventils und regelt einen Austrittsdruck in Abhängigkeit von einem elektrischen Steuersignal.

Weitere Vorteile, Merkmale und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen und in der Zeichnung werden die in der unten aufgeführten Liste der Bezugszeichen verwendeten Begriffe und zugeordneten Bezugszeichen verwendet. In der Zeichnung bedeutet:
- Fig. 1: ein axialer Längsschnitt eines erfindungsgemäßen elektrischen Feldgeräts;
- Fig. 2: ein axialer Längsschnitt einer alternativen Ausführungsform eines erfindungsgemäßen elektrischen Feldgeräts;
- Fig. 3: eine perspektivische Darstellung eines erfindungsgemäßen elektrischen Feldgeräts;
- Fig. 4: eine perspektivische Darstellung eines erfindungsgemäßen elektrischen Feldgeräts mit einer veränderten Winkelausrichtung eines zweiten Moduls gemäß Fig. 3;
- Fig. 5: eine Darstellung eines erfindungsgemäßen elektrischen Feldgeräts, das an einem Antriebsgehäuse einer Ventileinheit angeordnet ist;
- Fig. 6: eine perspektivische Darstellung einer alternativen Konfiguration einer Gehäuseaggregation eines erfindungsgemäßen elektrischen Feldgeräts; und
- Fig. 7: eine perspektivische axiale Draufsicht auf ein erstes Modul eines erfindungsgemäßen elektrischen Feldgeräts.

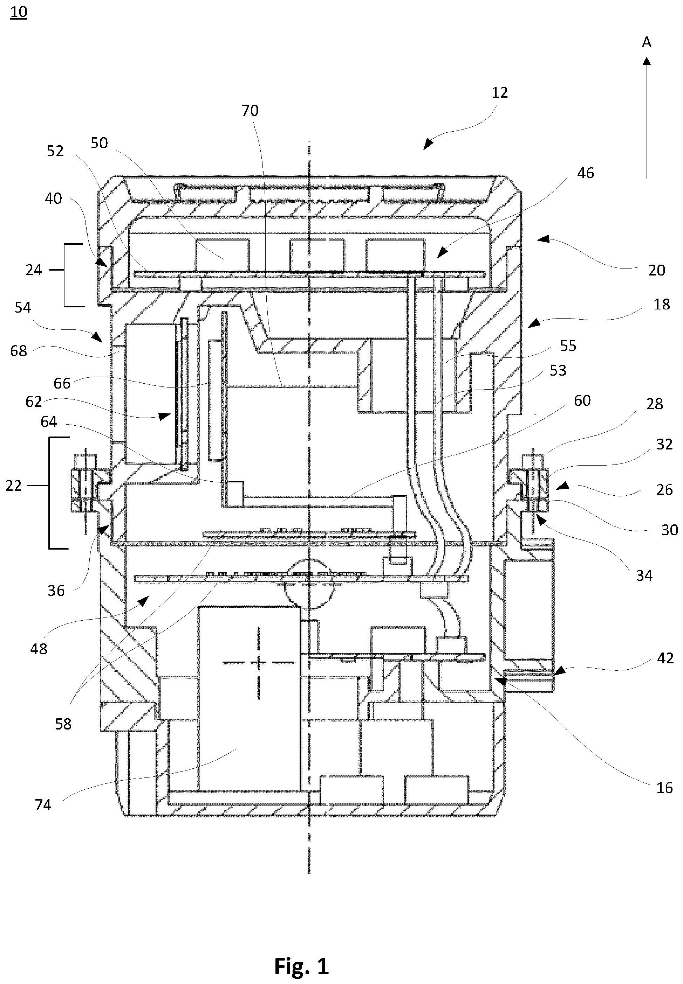

Fig. 1 zeigt in einer schematischen Darstellung einen axialen Längsschnitt eines elektrischen Feldgeräts 10. Das elektrische Feldgerät 10 ist vorliegend als ein Stellungsregler 10 zur Überwachung, Steuerung und/oder Regelung einer hier nicht dargestellten Ventileinheit 14 einer prozesstechnischen Anlage ausgebildet.

Das elektrische Feldgerät 10 weist ein Gehäuse 12 mit einer druckfesten Kapselung zum Einsatz in explosionsgefährdeten Bereichen auf. Das Gehäuse 12 ist als eine modular strukturierte Gehäuseaggregation 12 ausgebildet, die ein erstes Modul 16, ein zweites Modul 18 und ein Abdeckelement 20 umfasst. Das erste Modul 16 ist wahlweise sowohl unmittelbar als auch mittelbar mechanisch mit dem Abdeckelement 20 lösbar verbindbar. Vorliegend ist das erste Modul 16 unter Zwischenschaltung des zweiten Moduls 18 mittelbar mit dem Abdeckelement 20 verbunden.

Die Verbindung des ersten Moduls 16 mit dem zweiten Modul 18 sowie die Verbindung des zweiten Moduls 18 mit dem Abdeckelement 20 erfolgt in einem jeweiligen Anschlussbereich 22, 24. Aufgrund der jeweils identischen Ausbildung der Anschlussbereiche 22, 24 ist nur der Anschlussbereich 22, über den das erste Modul 16 mit dem zweiten Modul 18 verbunden ist, detailliert beschrieben.

Der Anschlussbereich 22 weist vorliegend eine Flanschverbindung 26 auf, die zur mechanischen Verbindung des zweiten Moduls 18 mit dem ersten Modul 16 dient. Über Schraubverbindungen 28 ist ein Anpressdruck auf die Flanschverbindung 26 aufgebracht. Die Flanschverbindung 26 ist durch das am ersten Modul 16 ausgebildete Flanschblatt 30 sowie das am zweiten Modul 18 ausgebildete Flanschblatt 32 gebildet.

Die Flanschblätter 30, 32 weisen jeweils Bohrungen 34 auf, die ein Lochmuster bilden. Über eine Lochpaarung der jeweiligen Lochmuster kann das zweite Modul 18 gegenüber dem ersten Modul 16 in unterschiedlichen Winkelausrichtungen um eine Längsachse A des Stellungsreglers 10 angeordnet sein, wobei die Längsachse A sich orthogonal zur Verbindungsebene des ersten Moduls 16 mit dem zweiten Modul 18 erstreckt. Die Veränderung der Winkelausrichtung des zweiten Moduls 18 gegenüber dem ersten Modul 16 ist vorliegend von der Enge des Rasters der jeweiligen Lochmuster abhängig.

Alternativ ist es denkbar, dass das Flanschblatt 32 des zweiten Moduls 18 ein Langlochmuster aufweist. Auf diese Weise ist die Winkelausrichtung des zweiten Moduls 18 gegenüber dem ersten Modul 16 nahezu stufenlos anpassbar.

Im Anschlussbereich 22 weisen das erste Modul 16 sowie das zweite Modul 18 vorliegend einen rotationssymmetrischen zylinderförmigen Übergangsbereich 36 auf. Im Bereich des Übergangsbereichs 36 greifen das erste Modul 16 und das zweite Modul 18 teleskopartig ineinander bzw. ist das zweite Modul 18 vom ersten Modul 16 umfänglich umschlossen. So weisen das erste Modul 16 und das zweite Modul 18 im Übergangsbereich 36 jeweils axial anliegende Flächen auf, über welche das erste Modul 16 und das zweite Modul 18 zueinander zentriert sind.

Die Verbindung des zweiten Moduls 18 mit dem Abdeckelement 20 erfolgt in einem Anschlussbereich 24, der identisch zum Anschlussbereich 22 ausgebildet ist. So weist der Anschlussbereich 24 einen hier nicht dargestellten Flansch 38 zur Verbindung des zweiten Moduls 18 mit dem Abdeckelement 20 sowie einen rotationssymmetrischen zylinderförmigen Übergang 40 mit jeweils axial anliegenden Flächen auf, wobei das zweite Modul 18 das Abdeckelement 20 im Bereich des Übergangs 40 radial umgreift.

Die Gehäuseaggregation 12 ist über eine am ersten Modul 16 ausgebildete mechanische Schnittstelle 42 mit einem hier nicht dargestellten Antriebsgehäuse 56 des ebenfalls nicht dargestellten Prozessventils verbunden. Die Verbindung kann beispielsweise über eine Verschraubung erfolgen.

Ferner weisen das erste Modul 16 sowie das zweite Modul 18 jeweils hier nicht dargestellte Anschlussdurchführungen 44 auf, über die hier ebenfalls nicht dargestellte Leitungen angeschlossen sind. Die Leitungen sind über eine Verbindungsschnittstelle 46 mit einer Kontrolleinheit 48 verbunden. Die Verbindungsschnittstelle 46 ist vorliegend mit Anschlussklemmen 50 ausgebildet, die auf einer Trägerplatte 52 mechanisch befestigt sind. Die im zweiten Modul 18 angeordnete Verbindungsschnittstelle 46 ist räumlich von der im ersten Modul 16 befestigten Kontrolleinheit 48 getrennt, sodass ein vorhandener Bauraum der Gehäuseaggregation geschickt genutzt ist. Dadurch kann das erste Modul 16 beispielsweise mit einer kompakten Baulänge ausgebildet sein.

Die Verbindung der Verbindungsschnittstelle mit der Kontrolleinheit erfolgt über eine elektrische Verkabelung 53, die vorliegend der Durchführung 55 zugeordnet ist, die druckfest ausgeführt sein kann. Eine zünddurchschlagsichere Durchführung der elektrischen Signalverbindung ermöglicht beispielsweise, dass der eingeschlossene Raum zwischen dem Abdeckelement 20 und dem zweiten Modul 18 mit einem unterschiedlichen bzw. geringeren Zündschutz ausgebildet sein kann gegenüber dem eingeschlossenen Raum zwischen dem ersten Modul 16 und dem zweiten Modul 18.

Die Kontrolleinheit 48 weist vorliegend eine zweiteilige Platine 58 auf, wobei die beiden Teile übereinanderliegend angeordnet sind. Die Platine 58 ist im ersten Modul 16 lagefest eingebaut. Sie dient als Überwachungs-, Steuerungs- und/oder Regeleinheit der hier nicht dargestellten Ventileinheit 14. So ist die Kontrolleinheit 48 vorliegend sowohl mit einem IP-Wandler 74, der im ersten Modul 16 angeordnet ist, elektrisch verbunden als auch mit einer hier nicht dargestellten Positionserkennungssensorik, die ebenfalls im ersten Modul 16 angeordnet ist.

Über die Kontrolleinheit 48 ist eine bidirektionale Kommunikation mit dem elektrischen Feldgerät 10 möglich. Dazu weist die Kontrolleinheit 48 ein Interface zu einer Leitstelle auf, wodurch das elektrische Feldgerät 10 aus einer Entfernung zum Aufstellungsort überwachbar und/oder bedienbar sein kann.

Vorliegend erfolgt die bidirektionale Kommunikation mit der Kontrolleinheit 48 über eine Bedieneinheit 62, die ein Trägerelement 64 umfasst, an dem ein Display-, Anzeige- und/oder Bedienelement angeordnet ist. Das Display- und/oder Anzeigeelement 66 ist vorliegend hinter einem druckfesten Sichtfenster 68 in einer Aussparung 54 des zweiten Moduls 18 angeordnet, und das Trägerelement 64 weist eine lösbare mechanische Verbindung 70 zum zweiten Modul 18 auf, sodass eine lagefeste Anordnung des Trägerelements 64 in einer gleichbleibenden Position gegenüber dem zweiten Modul 18 gewährleistet ist. Das Trägerelement 64 der Bedieneinheit 62 ist über eine lösbare Kommunikationsverbindung, die vorliegend als eine Kabelverbindung 60 ausgebildet ist, mit der Kontrolleinheit 48 elektrisch verbunden.

Bei einer Winkelveränderung des zweiten Moduls 18 gegenüber dem ersten Modul 16 unterzieht sich das Trägerelement 64 bzw. die Bedieneinheit 62 der gleichen Winkelveränderung, sodass die Position der Bedieneinheit 62 relativ zum zweiten Modul 18 unverändert bleibt. Dabei ermöglicht die Flexibilität der Kabelverbindung 60 eine Rotation des Trägerelements 64 von nahezu 360° gegenüber der Platine 58 der Kontrolleinheit 48. Ein hier nicht dargestellter mechanischer Anschlag begrenzt die Winkelausrichtung des zweiten Moduls 18 gegenüber dem ersten Modul 16, um insbesondere eine Beeinträchtigung der Kabelverbindung 60 durch Überdrehen zu verhindern.

Die Position der Bedieneinheit 62, die das Trägerelement 64 und das Display- und/oder Anzeigeelement 66 umfasst, ist vorliegend ausschließlich über die Winkelausrichtung des zweiten Moduls 18 gegenüber dem ersten Modul 16 veränderbar, wobei die Lage der Bedieneinheit 62 gegenüber dem zweiten Modul 18 unverändert bleibt. Auf diese Weise lässt sich die Position der Bedieneinheit 62 leicht an die Bauraumverhältnisse der Anlage anpassen, um eine gute Zugänglichkeit, einfache Ablesbarkeit und leichte Bedienung zu ermöglichen.

Ähnlich verhält es sich mit den hier nicht dargestellten Anschlussdurchführungen des zweiten Moduls 18, deren Position über eine Veränderung der Winkelausrichtung des zweiten Moduls 20 gegenüber dem ersten Modul 18 an die Bauraumverhältnisse der prozesstechnischen Anlage anpassbar sind.

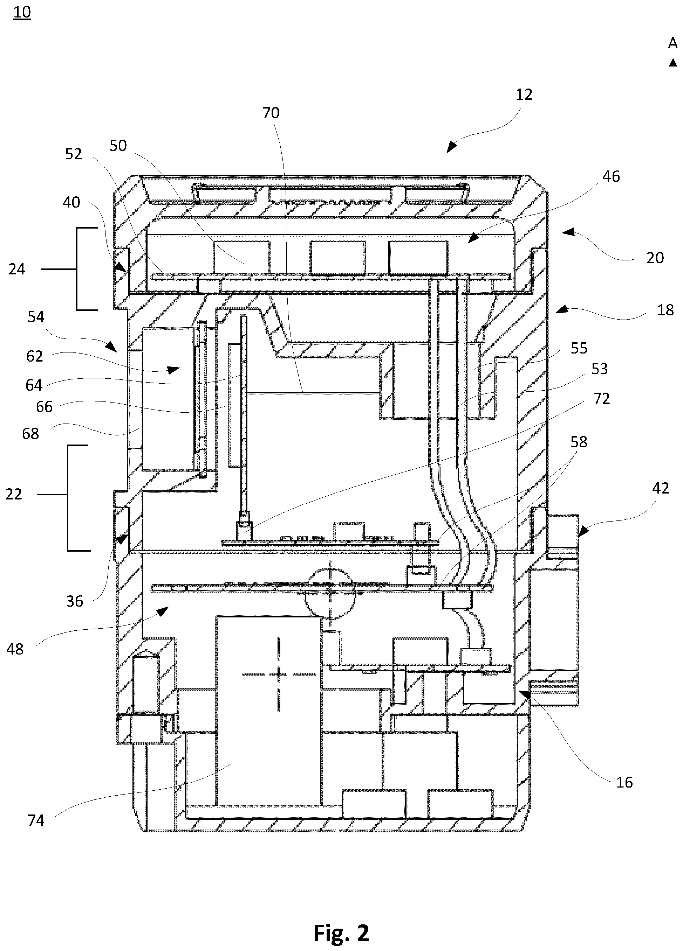

In Fig. 2 ist ein axialer Längsschnitt einer alternativen Ausführungsform des Stellungsreglers 10 dargestellt. Die Gehäuseaggregation 12 umfasst das erste Modul 16, das zweite Modul 18 sowie das Abdeckelement 20, die jeweils über die Anschlussbereiche 22, 24 miteinander verbunden sind. Die Anschlussbereiche 22, 24 weisen jeweils einen rotationssymmetrischen zylinderförmigen Übergang 36, 40 auf. In den Bereichen der jeweiligen Übergänge 36, 40 greifen die jeweiligen Gehäusebauteile 16, 18, 20 teleskopartig ineinander und weisen jeweils axial anliegende Flächen auf, über welche die Gehäusebauteile 16, 18, 20 zueinander zentriert sind.

In den Anschlussbereichen 22, 24 können die Gehäusebauteile 16, 18, 20, wie oben in Fig. 1 schon beschrieben wurde, beispielsweise über einen hier nicht dargestellten Flansch 26, 38 miteinander verbunden sein. Alternativ ist es denkbar, dass das zweite Modul 18 gegenüber dem ersten Modul 16 stufenlos justierbar ist, indem das erste Modul 16 sowie das zweite Modul 18 im Anschlussbereich 22 mit einem Außengewinde ausgebildet sind, welches mit einem Innengewinde eines beweglichen Gewindestücks, beispielsweise einer Überwurfmutter, verschraubbar ist. In vorteilhafter Weise weist die Verbindung über einen Drehschluss einen geringen Spalt auf. Das bewegliche Gewindestück kann insbesondere den Anschlussbereich 22 radial umgreifen und beispielsweise über einen am Gehäuse 16 ausgebildeten Absatz fixierbar sein. Durch die stufenlos anpassbare Winkelausrichtung des zweiten Moduls 18 gegenüber dem ersten Modul 16 ist das zweite Modul 18 über eine Rotation relativ zum ersten Modul 16 optimal an die Bauraumverhältnisse einer prozesstechnischen Anlage anpassbar.

Wie schon in Fig. 1 beschrieben wurde, weist das erste Modul 16 vorliegend eine mechanische Schnittstelle 42 zur Fixierung an einem hier nicht dargestellten Antriebsgehäuse 56 eines ebenfalls nicht dargestellten Prozessventils auf. Das erste Modul 16 sowie das zweite Modul 18 weisen jeweils hier nicht dargestellte Anschlussdurchführungen 44 auf, die zum Anschluss von hier ebenfalls nicht dargestellten Leitungen dienen, die mit einer Kontrolleinheit 48 des Stellungsreglers 10 elektrisch verbunden sind.

Die lagefest gegenüber dem ersten Modul 16 eingebaute Kontrolleinheit 48 umfasst insbesondere eine, wie in Fig.1 beschriebene, zweiteilige Platine 58. Die Kontrolleinheit 48 und ein Trägerelement 64 der Bedieneinheit 62 sind über eine lösbare Kommunikationsverbindung miteinander verbunden. Insbesondere sind sie über einen an der Platine 58 ausgebildeten Steckverbinder 72 verbunden, der das Trägerelement 64, an dem ein Display-, Anzeige- und/oder Bedienelement befestigt sind, aufnimmt. Die Platine 58 weist eine Vielzahl von Steckverbindern 72 in unterschiedlichen Positionen auf, so dass die Lage des Trägerelements 64 an der Platine 58 durch Umstecken veränderbar ist.

Die Platine 58 reflektiert über die Steckverbinder 72 die Symmetrieanforderungen des zweiten Moduls 18, wodurch die Position des Display- und/oder Anzeigeelements 66 optimal an die Position der Aussparung des zweiten Moduls 18 anpassbar ist. Bei einer Winkelausrichtung des zweiten Moduls 18 gegenüber dem ersten Modul 16 erfolgt das Umstecken des Trägerelements 64 derart, dass die lagefeste Anordnung des Trägerelements 64 gegenüber dem zweiten Modul 18 gewährleistet ist. Das bedeutet, dass das Trägerelement 64 derart umgesteckt wird, dass das Display- und/oder Anzeigeelement 66 der Bedieneinheit 62 hinter einem druckfesten Sichtfenster 68 in einer Aussparung des zweiten Moduls 18 angeordnet bleibt. Das Trägerelement 64 kann zusätzlich zur Verbindung mit der Platine 58 mittels Steckverbindung 72 über eine mechanische Verbindung 70 mit dem zweiten Modul 18 verbunden sein.

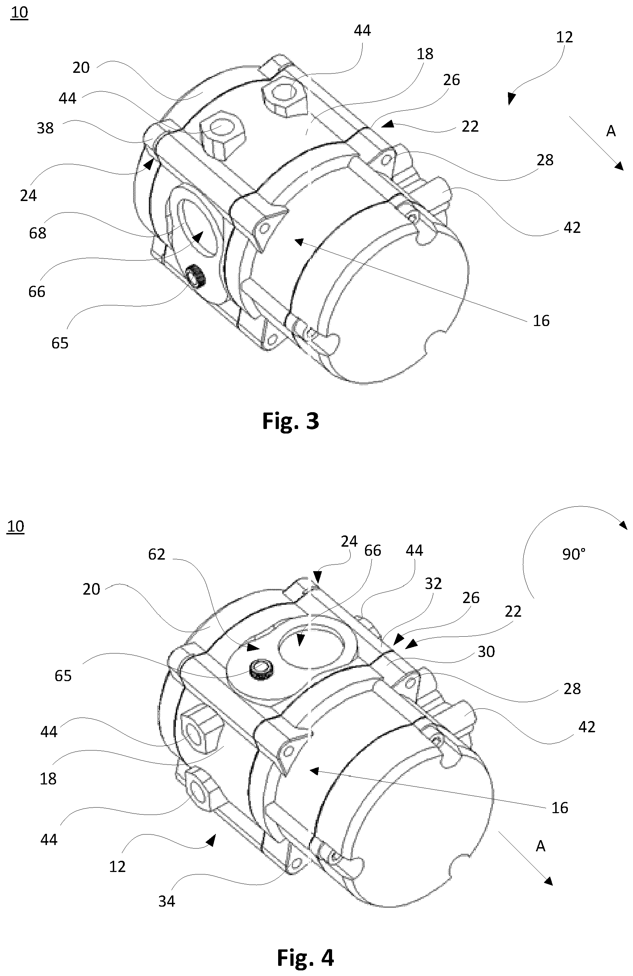

Fig. 3 zeigt eine perspektivische Darstellung eines erfindungsgemäßen elektrischen Feldgeräts 10, das vorliegend als ein Stellungsregler 10 ausgebildet ist und eine modular strukturierte Gehäuseaggregation 12 umfasst, die ein erstes Modul 16, ein zweites Modul 18 und ein Abdeckelement 20 aufweist.

Das erste Modul 16 weist eine mechanische Schnittstelle 42 auf, über die es mit einem hier nicht dargestellten Antriebsgehäuse 56 eines Prozessventils lagefest verbindbar ist.

Das erste Modul 16 sowie das zweite Modul 18 weisen Anschlussdurchführungen 44 auf, an die hier nicht dargestellte Leitungen anschließbar sind, die zur elektrischen Verbindung des Stellungsreglers 10 mit einem Antrieb des Prozessventils dienen. Das zweite Modul 18 weist in Umfangsrichtung eine Vielzahl von Anschlussdurchführungen 44 auf.

Ferner weist das zweite Modul 18 ein Sichtfenster 68 auf, das beispielsweise mit einer druckfesten Glasscheibe ausgebildet ist, hinter der ein Display- und/oder Anzeigeelement 66 einer lagefest mit dem zweiten Modul 18 angeordneten Bedieneinheit 62 angeordnet ist. Die Bedieneinheit 62 weist vorliegend auch ein Bedienelement 65 auf, z. B. eine Bedienschraube 65, die das zweite Modul 18 durchsetzt und über die eine Bedienung des elektrischen Feldgeräts 10 von außen am Gehäuse 12 ermöglicht ist.

Vorliegend ist das erste Modul 16 unter Zwischenschaltung des zweiten Moduls 18 mittelbar mit dem Abdeckelement 20 verbunden. Die Verbindung der jeweiligen Gehäusebauteile 16, 18, 20 erfolgt jeweils in einem Anschlussbereich 22, 24. Die jeweiligen Anschlussbereiche 22, 24 sind einheitlich festgelegt, so dass das erste Modul 16 wahlweise sowohl mittelbar über das zweite Modul 18 mit dem Abdeckelement 20 als auch unmittelbar mit dem Abdeckelement 20 verbindbar ist. So weisen die Anschlussbereiche 22, 24 vorliegend jeweils einen Flansch 26, 38 auf, über den die jeweiligen Gehäusebauteile 16, 18, 20 lösbar miteinander verbunden sind. Die Flansche 26, 38 weisen Bohrungen 34 für Schraubverbindungen 28 auf, über die ein Anpressdruck auf den jeweiligen Flansch 26, 38 angebracht ist.

Aus Fig. 4 geht hervor, dass das zweite Modul 18 der Gehäuseaggregation 12 gegenüber dem ersten Modul 16 in unterschiedlichen Winkelausrichtungen um die Längsachse A fixierbar ist, wobei sich die Längsachse A orthogonal zur Verbindungsebene des ersten Moduls 16 mit dem zweiten Modul 18 erstreckt. Das bedeutet, dass das zweite Modul 18 gegenüber dem ersten Modul 16 axial in unterschiedlichen Rotationswinkeln ausrichtbar ist, wie aus einem Vergleich der Fig. 4 gegenüber der Fig. 3 hervorgeht.

Der Anschlussbereich 22 weist insbesondere einen Flansch 26 zur Verbindung des ersten Moduls 16 mit dem zweiten Modul 18 auf. Der Flansch 26 weist Flanschblätter 30, 32 auf, die jeweils am ersten Modul 16 und am zweiten Modul 18 ausgebildet sind. Die jeweiligen Flanschblätter 30, 32 weisen Bohrungen 34 auf, die ein Lochmuster ausbilden. Über eine Lochpaarung der Lochmuster der jeweiligen Flanschblätter 30, 32 sind das erste Modul 16 und das zweite Modul 18 zueinander zentriert. Die Winkelausrichtung des zweiten Moduls 18 gegenüber dem ersten Modul 16 ist über die Lochpaarung des Flansches 26 veränderbar, wobei die Veränderung der Winkelausrichtung von der Enge des Rasters der jeweiligen Lochmuster der Flanschblätter 30, 32 abhängig ist. Vorliegend ist das zweite Modul 18 beispielsweise 90° um die Längsachse A gegenüber dem in Fig. 3 dargestellten zweiten Modul 18 rotiert. Auf diese Weise ist die Winkelausrichtung des zweiten Moduls 18 gegenüber dem ersten Modul 16 um die Längsachse des elektrischen Feldgeräts 10 in vorteilhafter Weise anpassbar, so dass die am zweiten Modul 18 ausgebildete Bedieneinheit 62 sowie Anschlussdurchführungen 44 eine optimal an die Bauraumverhältnisse der Anlage angepasste Position einnehmen können.

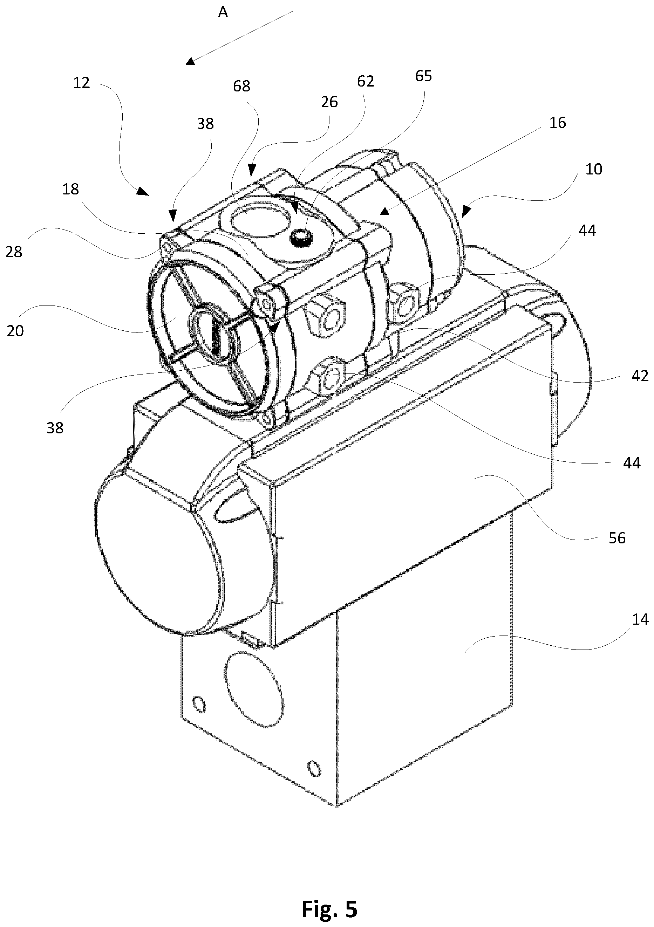

Fig. 5 zeigt den in Fig. 3 und Fig. 4 dargestellten Stellungsregler 10 in einer Anordnung mit einem Antriebsgehäuse 56 eines Antriebs einer Ventileinheit 14. Die modular strukturierte Gehäuseaggregation 12 zeigt das erste Modul 16, das über den Flansch 26 mit dem zweiten Modul 18 verbunden ist, welches wiederum über den Flansch 38 mit dem Abdeckelement 20 verbunden ist.

Das erste Modul 16 ist mit einer mechanischen Schnittstelle 42 ausgebildet, die zur Verbindung mit dem Antriebsgehäuse 56 dient. Diese Verbindung kann insbesondere über eine Verschraubung erfolgen. Im ersten Modul 16 sind der IP-Wandler 74 zur Regelung des Ausgangsdrucks und die Positionserfassungssensorik zur Erfassung der Stellgliedposition der Ventileinheit 14 integriert. Sie sind zur Positionierung und/oder Regelung des Stellgliedes der Ventileinheit 14 mit der Kontrolleinheit 48 kommunizierend verbunden.

Das erste Modul 16 sowie das zweite Modul 18 weisen Anschlussdurchführungen 44 auf, über die hier nicht dargestellte Leitungen angeschlossen sind, um den Stellungsregler elektrisch zu verbinden.

Das zweite Modul 18 weist zusätzlich zu den Anschlussdurchführungen 44 eine Bedieneinheit 62 auf, die ein Display-, Anzeige- und/oder Bedienelement aufweist. Das Display- und/oder Anzeigeelement ist in einer Aussparung des zweiten Moduls 18 hinter einem druckfesten Sichtfenster 68 angeordnet. Über das Bedienelement 65 der Bedieneinheit 62 ist eine Bedienung des Stellungsreglers 10 von außen am Gehäuse 12 möglich.

Das erste Modul 16 ist über die mechanische Schnittstelle 42 in einer festen Lage am Antriebsgehäuse 56 fixiert. Das zweite Modul 18 ist gegenüber dem ersten Modul 16 und demzufolge gegenüber dem Antriebsgehäuse 56 in unterschiedlichen Winkelausrichtungen um die Längsachse A fixierbar. Dadurch sind die Positionen der jeweiligen Anschlussdurchführungen 44 und der Bedieneinheit 62 bzw. des Display-, Anzeige- und/oder Bedienelements 66, 65, die jeweils lagefest gegenüber dem zweiten Modul 18 angeordnet sind, über die unterschiedlichen Winkelausrichtungen des zweiten Moduls 18 optimal an die Bauraumverhältnisse der prozesstechnischen Anlage anpassbar. So lässt sich die Position der Bedieneinheit 62 leicht an die Bauraumverhältnisse der Anlage anpassen, um eine gute Zugänglichkeit, einfache Ablesbarkeit und leichte Bedienung zu sichern. Ähnlich verhält es sich mit der Position der Anschlussdurchführungen 44, über welche die Zuführbedingungen der elektrischen Leitungen leicht an die Anbauverhältnisse der Anlage anpassbar sind.

In Fig. 1 bis Fig. 5 weisen die erfindungsgemäßen elektrischen Feldgeräte 10 jeweils eine Gehäuseaggregation 12 auf, bei der das erste Modul 16 mittelbar mit dem Abdeckelement 20 unter Zwischenschaltung des zweiten Moduls 18 mechanisch verbunden ist.

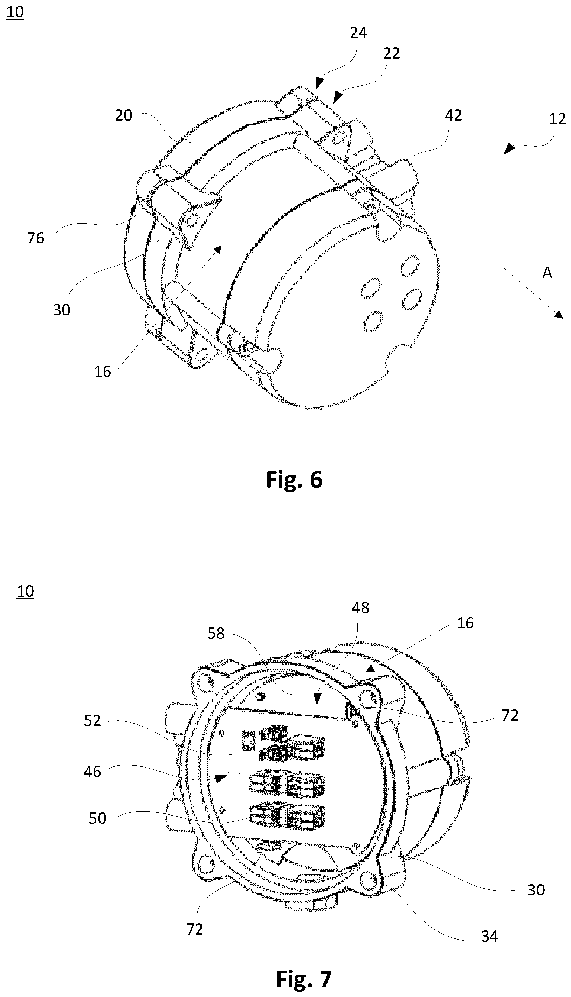

In Fig. 6 und Fig. 7 ist jeweils eine perspektivische Darstellung einer alternativen Konfiguration des Gehäuses 12 des Stellungsreglers 10 gezeigt, die unter Verwendung eines einheitlichen ersten Moduls 16 sowie eines einheitlichen Abdeckelements 20 erfolgt. Das erste Modul 16 sowie das Abdeckelement 20 dienen beide als Grundkörper für die jeweils unterschiedlichen Konfigurationen der Gehäuseaggregation 12. Dadurch, dass das erste Modul 16, das zweite Modul 18 und das Abdeckelement 20 jeweils einheitlich festgelegte Anschlussbereiche 22, 24 aufweisen, über die sie jeweils miteinander verbindbar sind, kann das erste Modul 16, wie in Fig. 6 dargestellt ist, unmittelbar mit dem Abdeckelement 20 verbunden sein.

Vorliegend sind der Anschlussbereich 22 des ersten Moduls 16 und der Anschlussbereich 24 des Abdeckelements 20 zentriert zueinander angeordnet. Die Anschlussbereiche 22, 24 weisen jeweils ein Flanschblatt 30, 76 mit Bohrungen auf, die ein Lochmuster ausbilden. Über eine Lochpaarung der jeweiligen Lochmuster sind die Flanschblätter 30, 76 vorliegend miteinander verschraubt.

In vorteilhafter Weise weist die vorliegende Konfiguration der Gehäuseaggregation 12, die das erste Modul 16 und das Abdeckelement 20 umfasst, eine vereinfachte Anordnung mit einer reduzierten Anzahl von Gehäusebauteilen 16, 20 auf. Dadurch weist der Stellungsregler 10 eine geringere Größe, insbesondere eine geringere axiale Erstreckung, auf. Durch die kurze Baulänge des vorliegenden Gehäuses 12 ist der Stellungsregler 10 einfach an eine prozesstechnische Anlage anpassbar, die beispielsweise einen geringen Bauraum zur Verfügung hat. Die Verbindung des Stellungsreglers mit einem Antriebsgehäuse 56 einer Ventileinheit 14 erfolgt über die am ersten Modul ausgebildete mechanische Schnittstelle 42. Die elektrische Verbindung des Stellungsreglers mit einem Antrieb der Ventileinheit erfolgt über hier nicht dargestellte Anschlussdurchführungen 44, die ebenfalls am ersten Modul 16 ausgebildet sind.

In Fig. 7 ist eine perspektivische axiale Draufsicht auf das erste Modul 16 des Gehäuses 12 gemäß Fig. 6 gezeigt.

Im ersten Modul 16 sind der hier nicht dargestellte IP-Wandler 74 zur Regelung des Austrittsdrucks, die hier ebenfalls nicht dargestellte Positionserfassungssensorik zur Erfassung der Stellgliedposition der Ventileinheit 14 sowie die Kontrolleinheit 48 angeordnet.

Die Kontrolleinheit 48 ist lagefest gegenüber dem ersten Modul 16 angeordnet. Sie weist vorliegend eine Leiterplatte oder Platine 58 auf, die insbesondere im ersten Modul 16 befestigt ist. Auf der Platine 58 sind Steckverbinder 72 angeordnet, über die das Trägerelement 64 der Bedieneinheit 62 mit der Kontrolleinheit 48 elektrisch verbindbar ist. Die Positionen der Steckverbinder 72 reflektieren die Symmetrie der Bohrungen des Flanschblattes 30 und somit die Symmetrieanforderungen des zweiten Moduls 18. In der vorliegenden Konfiguration des Gehäuses 12 des Stellungsreglers 10 fallen das Trägerelement 64 bzw. die Bedieneinheit 62 sowie das zweite Modul 18 weg.

Zur bidirektionalen Kommunikation mit dem elektrischen Feldgerät 10 weist die Kontrolleinheit 48 ein Interface zu einer Leitstelle auf. Die Leitstelle kann über die Verbindungsschnittstelle 46, die separat zur Kontrolleinheit 48 ausgebildet ist, mit der Kontrolleinheit 48 elektrisch verbunden sein. Dazu weist die Verbindungsschnittstelle 46 vorliegend Anschlussklemmen 50 auf, die auf einer Trägerplatte 52 befestigt sind. Die Trägerplatte 52 kann beispielsweise im ersten Modul 16 lagefest befestigt sein.

Die Kommunikation zwischen der Leitstelle und der Kontrolleinheit 48 kann z. B. über ein BUS-System erfolgen. So ist die Kontrolleinheit 48 beispielsweise aus einer Entfernung zum Aufstellungsort des Gehäuses 12 des elektrischen Feldgeräts 10 überwachbar und/oder bedienbar. Die vorliegende Anordnung des elektrischen Feldgeräts 10 ist z. B. von Vorteil bei prozesstechnischen Anlagen, die schlecht zugänglich sind, besonders rauen Umweltbedingungen oder einer erhöhten Vibrationsbelastung ausgesetzt sind.

### Bezugszeichenliste

- 10: elektrisches Feldgerät
- 12: Gehäuse
- 14: Ventileinheit
- 16: erstes Modul
- 18: zweites Modul
- 20: Abdeckelement
- 22: Anschlussbereich
- 24: Anschlussbereich
- 26: Flansch
- 28: Verschraubung
- 30: Flanschblatt
- 32: Flanschblatt
- 34: Bohrungen
- 36: Übergangsbereich
- 38: Flansch
- 40: Übergangsbereich
- 42: Schnittstelle
- 44: Anschlussdurchführungen
- 46: Verbindungsschnittstelle
- 48: Kontrolleinheit
- 50: Anschlussklemmen
- 52: Trägerplatte
- 53: elektrische Verkabelung
- 54: Aussparung
- 55: Durchführung (optional druckfest)
- 56: Antriebsgehäuse
- 58: doppelte Platine
- 60: Kabelverbindung
- 62: Bedieneinheit
- 64: Trägerelement
- 65: Bedienelement
- 66: Display- und/oder Anzeigeelement
- 68: Sichtfenster
- 70: mechanische Verbindung
- 72: Steckverbinder
- 74: IP-Wandler
- 76: Flanschblatt

## Patentansprüche

1. Elektrisches Feldgerät (10) der Zündschutzart der druckfesten Kapselung zum Einsatz in explosionsgefährdeten Bereichen, das zur Steuerung und/oder Regelung einer Ventileinheit einer prozesstechnischen Anlage dient, umfassend ein Gehäuse (12), in dem eine elektronische Bauteile umfassende Kontrolleinheit (48), die als Überwachungs-, Steuerungs- und/oder Regeleinheit dient, angeordnet ist, wobei die Kontrolleinheit (48) eine lösbare Kommunikationsverbindung zu einer Bedieneinheit (62) aufweist, wobei das Gehäuse (12) über eine mechanische Schnittstelle (42) mit einem Antriebsgehäuse der Ventileinheit verbindbar ist, und wobei das Gehäuse wenigstens eine Anschlussdurchführung (44) aufweist, über die wenigstens eine Leitung anschließbar ist, die über eine Verbindungsschnittstelle (46) mit der Kontrolleinheit (48) verbunden sind,
wobei
das Gehäuse (12) als eine modular strukturierte Gehäuseaggregation ausgebildet ist, die ein erstes Modul (16), ein zweites Modul (20) und ein Abdeckelement (20) aufweist, wobei das erste Modul (16) mit der mechanischen Schnittstelle (42) zum Antriebsgehäuse sowie der Anschlussdurchführung (44) ausgebildet ist, wobei die Kontrolleinheit (48) im ersten Modul (16) befestigt ist und ein Interface zu einer Leitstelle aufweist, wobei das erste Modul (16) mittelbar mechanisch mit einem Abdeckelement (20) lösbar verbunden ist, wobei die mittelbare Verbindung des ersten Moduls (16) mit dem Abdeckelement (20) unter Zwischenschaltung des zweiten Moduls (18) erfolgt, wobei die Bedieneinheit (62) lagefest im zweiten Modul (18) angeordnet ist, und wobei das zweite Modul (18) gegenüber dem ersten Modul (16) in unterschiedlichen Winkelausrichtungen um eine Längsachse des elektrischen Feldgeräts fixierbar ist, wobei das erste Modul (16) und das Abdeckelement (20) auch unmittelbar mechanisch lösbar miteinander verbindbar sind, wobei die Kontrolleinheit (48) eine Platine (58) aufweist und die Bedieneinheit (62) ein Trägerelement (64) umfasst, an dem ein Display-, Anzeige- und/oder Bedienelement (65) angeordnet sind, wobei die elektrisch lösbare Kommunikationsverbindung zwischen der Kontrolleinheit (48) und der Bedieneinheit (62) über die Platine (58) und das Trägerelement (64) erfolgt, und wobei die Platine (58) und das Trägerelement (64) über ein Anschlusselement in unterschiedliche Winkelausrichtungen zueinander anordenbar sind.

2. Elektrisches Feldgerät nach Anspruch 1, **dadurch gekennzeichnet, dass** die Platine (58) der Kontrolleinheit (48) elektrisch leitend mit der Verbindungsschnittstelle (46) verbunden ist, wobei die Verbindungsschnittstelle (46) Anschlussklemmen (50) aufweist, die im zweiten Modul (18) unterhalb des Abdeckelements (20) angeordnet sind.

3. Elektrisches Feldgerät nach Anspruch 1 oder 2, **dadurch gekennzeichnet, dass** das Anschlusselement als ein Steckverbinder auf der Platine (58) der Kontrolleinheit (48) ausgebildet ist, wobei die Platine (58) eine Vielzahl von Steckverbindern in unterschiedlichen Positionen aufweist.

4. Elektrisches Feldgerät nach Anspruch 1 oder 2, **dadurch gekennzeichnet, dass** das Anschlusselement als eine Kabelverbindung ausgebildet ist.

5. Elektrisches Feldgerät nach einem der vorangehenden Ansprüche, **dadurch gekennzeichnet, dass** das erste Modul (16), das zweite Modul (18) und das Abdeckelement (20) jeweils einen Anschlussbereich (22, 24) aufweisen, über welchen sie jeweils mechanisch miteinander verbindbar sind.

6. Elektrisches Feldgerät nach Anspruch 5, **dadurch gekennzeichnet, dass** die jeweiligen Anschlussbereiche einen rotationssymmetrischen zylinderförmigen Übergangsbereich (36) aufweisen, wobei die jeweiligen Anschlussbereiche derart ineinandergreifen, dass sie jeweils axial anliegende Flächen aufweisen.

7. Elektrisches Feldgerät nach den Ansprüchen 5 und 6, **dadurch gekennzeichnet, dass** die jeweiligen Anschlussbereiche (22, 24) über eine formschlüssige und/oder kraftschlüssige Verbindung miteinander verbindbar sind.

8. Elektrisches Feldgerät nach Anspruch 7, **dadurch gekennzeichnet, dass** die Verbindung in axialer Richtung über eine Verschraubung einer Lochpaarung der jeweiligen Anschlussbereiche erfolgt.

9. Elektrisches Feldgerät nach einem der Ansprüche 5 bis 7, **dadurch gekennzeichnet, dass** der Anschlussbereich (22) zwischen dem ersten und dem zweiten Modul derart ausgebildet ist, dass der Anschlussbereich des ersten Moduls stufenlos justierbar ist.

10. Elektrisches Feldgerät nach Anspruch 9, **dadurch gekennzeichnet, dass** der Anschlussbereich des zweiten Moduls ein Langlochmuster aufweist.

11. Elektrisches Feldgerät nach einem der Ansprüche 9 bis 10, **dadurch gekennzeichnet, dass** das erste Modul (16) gegenüber dem zweiten Modul (18) einen Drehanschlag aufweist.

12. Elektrisches Feldgerät nach einem der vorangehenden Ansprüche, **dadurch gekennzeichnet, dass** das zweite Modul (18) wenigstens eine Anschlussdurchführung aufweist.

13. Elektrisches Feldgerät nach einem der vorangehenden Ansprüche, **dadurch gekennzeichnet, dass** im ersten Modul eine Positionserkennungssensorik für eine Lagemessung einer Ventilgliedstellung angeordnet ist.

14. Elektrisches Feldgerät nach einem der vorangehenden Ansprüche, **dadurch gekennzeichnet, dass** im ersten Modul ein IP-Wandler angeordnet ist.

15. Prozessventil einer prozesstechnischen Anlage, umfassend eine Ventileinheit, die ein Stellventil sowie einen Antrieb, der in einem Antriebsgehäuse angeordnet ist, aufweist, wobei das Antriebsgehäuse mit einem elektrischen Feldgerät verbunden ist, das zur Steuerung und/oder Regelung eines Stellglieds des Stellventils dient, **dadurch gekennzeichnet, dass** das elektrische Feldgerät (10) nach einem der vorangehenden Ansprüche ausgebildet ist.

## Claims

1. Electrical field device (10) of the ignition protection type of pressure-resistant encapsulation for use in potentially explosive areas that is used to control and/or regulate a valve unit of a process plant, comprising a housing (12) in which a control unit (48) containing electronic components is arranged that is used as a monitoring, control, and/ or regulation unit, which control unit (48) has a disconnectable communication link to an operating unit (62), which housing (12) is adapted to be connected, via a mechanical interface (42), to an actuator housing of the valve unit, and which housing has at least one connection bushing (44) via which at least one cable can be connected, which are connected to the control unit (48) via a connection interface (46), wherein the housing (12) is designed as a modular housing assembly comprising a first module (16), a second module (20), and a cover element (20), with the first module (16) being provided with the mechanical interface (42) to the actuator housing as well as the connection bushing (44), with the control unit (48) being mounted in the first module (16) and having an interface to a control center, which first module (16) is connected indirectly and mechanically to a cover element (20) in a detachable manner, with the indirect connection between the first module (16) and the cover element (20) being implemented with the second module (18) being interposed in between, which control unit (62) is fixedly mounted in the second module (18), and which second module (18) can be fixed relative to the first module (16) at different angles about a longitudinal axis of the electrical field device, wherein the first module (16) and the cover element (20) can also be directly and mechanically connected to one another in a detachable manner, with the control unit (48) comprising a circuit board (58) and the control unit (62) comprising a support element (64) on which a display, indicator, and/or control element (65) is arranged, wherein the electrically disconnectable communication link between the control unit (48) and the operating unit (62) is established via the circuit board (58) and the support element (64), and wherein the circuit board (58) and the support element (64) can be oriented at different angles to each other using a connecting element.

2. Electrical field device according to claim 1, **characterized in that** the circuit board (58) of the control unit (48) is electrically conductively connected to the connection interface (46), which connection interface (46) has connection terminals (50) that are arranged below the cover element (20) in the second module (18).

3. Electrical field device according to claim 1 or 2, **characterized in that** the connecting element is designed as a connector on the circuit board (58) of the control unit (48), with a plurality of connectors being arranged in different positions on the circuit board (58).

4. Electrical field device according to claim 1 or 2, **characterized in that** the connecting element is configured as a cable connection.

5. Electrical field device according to any one of the preceding claims, **characterized in that** the first module (16), the second module (18), and the cover element (20) each have a connection area (22, 24) via which they can each be mechanically connected to one another.

6. Electrical field device according to claim 5, **characterized in that** the respective connection areas comprise a rotationally symmetrical cylindrical transition area (36), with the respective connection areas engaging with each other in such a manner that they each have surfaces that abut axially.

7. Electrical field device according to claims 5 and 6, **characterized in that** the respective connection areas (22, 24) can be connected to one another via a positive-locking and/or force-locking connection.

8. Electrical field device according to claim 7, **characterized in that** the connection in the axial direction is made by a screw-connection of a pair of holes in the respective connection areas.

9. Electrical field device according to any one of claims 5 to 7 above, **characterized in that** the connection area (22) between the first and second modules is designed such that the connection area of the first module is infinitely adjustable.

10. Electrical field device according to claim 9, **characterized in that** the connection area of the second module has a slotted-hole pattern.

11. Electrical field device according to any one of claims 9 to 10 above, **characterized in that** the first module (16) has a rotational stop relative to the second module (18).

12. Electrical field device according to any one of the preceding claims, **characterized in that** the second module (18) has at least one connection bushing.

13. Electrical field device according to any one of the preceding claims, **characterized in that** a position sensing system for measuring the position of a valve element is arranged in the first module.

14. Electrical field device according to any one of the preceding claims, **characterized in that** an IP converter is arranged in the first module.

15. Process valve for a process plant, comprising a valve unit that includes a control valve and an actuator arranged in an actuator housing, with the actuator housing being connected to an electrical field device that is used to control and/or regulate a positioner of the control valve, **characterized in that** the electrical field device (10) is designed according to any one of the preceding claims.

## Revendications

1. Appareil de terrain électrique (10) à blindage résistant à la pression du type antidéflagrant destiné à être utilisé dans des zones à risque d'explosion, qui sert à la commande et/ou à la régulation d'une unité de vanne d'une installation technique, comprenant un boîtier (12), dans lequel est disposée une unité de contrôle (48) comprenant des composants électroniques, qui sert d'unité de surveillance, de commande et/ou de régulation, dans lequel l'unité de contrôle (48) présente une liaison de communication libérable avec une unité de commande utilisateur (62), dans lequel le boîtier (12) peut être relié à un boîtier d'entraînement de l'unité de vanne par l'intermédiaire d'une interface mécanique (42), et dans lequel le boîtier présente au moins une traversée de raccordement (44), par l'intermédiaire de laquelle au moins une conduite peut être raccordée, qui sont reliées à l'unité de contrôle (48) par l'intermédiaire d'une interface de liaison (46),
dans lequel
le boîtier (12) est réalisé sous la forme d'un ensemble boîtier à structure modulaire, qui présente un premier module (16), un deuxième module (18) et un élément de recouvrement (20), dans lequel le premier module (16) est réalisé avec l'interface mécanique (42) au boîtier d'entraînement ainsi qu'avec la traversée de raccordement (44), dans lequel l'unité de contrôle (48) est attachée dans le premier module (16) et présente une interface avec un centre de commande, dans lequel le premier module (16) est relié mécaniquement indirectement de manière libérable à un élément de recouvrement (20), dans lequel la liaison indirecte du premier module (16) à l'élément de recouvrement (20) s'effectue avec interposition du deuxième module (18), dans lequel l'unité de commande utilisateur (62) est disposée en position fixe dans le deuxième module (18), et dans lequel le deuxième module (18) peut être fixé dans différentes orientations angulaires autour d'un axe longitudinal de l'appareil de terrain électrique par rapport au premier module (16), dans lequel le premier module (16) et l'élément de recouvrement (20) peuvent être reliés entre eux mécaniquement de manière libérable également directement, dans lequel l'unité de contrôle (48) présente une carte de circuits imprimés (58) et l'unité de commande utilisateur (62) comprend un élément de support (64), sur lequel sont disposés un élément d'affichage, un élément de visualisation et/ou un élément de commande utilisateur (65), dans lequel la liaison de communication électriquement libérable entre l'unité de contrôle (48) et l'unité de commande utilisateur (62) s'effectue par l'intermédiaire de la carte de circuits imprimés (58) et de l'élément de support (64), et dans lequel la carte de circuits imprimés (58) et l'élément de support (64) peuvent être disposés dans différentes orientations angulaires l'une par rapport à l'autre par l'intermédiaire d'un élément de raccordement.

2. Appareil de terrain électrique selon la revendication 1, **caractérisé en ce que** la carte de circuits imprimés (58) de l'unité de contrôle (48) est reliée à l'interface de liaison (46) de manière électro-conductrice, dans lequel l'interface de liaison (46) présente des bornes de raccordement (50), qui sont disposées au-dessous de l'élément de recouvrement (20) dans le deuxième module (18).

3. Appareil de terrain électrique selon la revendication 1 ou 2, **caractérisé en ce que** l'élément de raccordement est réalisé sous la forme d'un connecteur à fiche sur la carte de circuits imprimés (58) de l'unité de contrôle (48), dans lequel la carte de circuits imprimés (58) présente une pluralité de connecteurs à fiche dans différentes positions.

4. Appareil de terrain électrique selon la revendication 1 ou 2, **caractérisé en ce que** l'élément de raccordement est réalisé sous la forme d'une liaison par câble.

5. Appareil de terrain électrique selon l'une quelconque des revendications précédentes, **caractérisé en ce que** le premier module (16), le deuxième module (18) et l'élément de recouvrement (20) présentent respectivement une zone de raccordement (22, 24), par l'intermédiaire de laquelle ils peuvent être reliés respectivement mécaniquement entre eux.

6. Appareil de terrain électrique selon la revendication 5, **caractérisé en ce que** les zones de raccordement respectives présentent une zone de transition (36) cylindrique à symétrie de rotation, dans lequel les zones de raccordement respectives s'interpénètrent de telle sorte qu'elles présentent respectivement des surfaces axialement attenantes.

7. Appareil de terrain électrique selon les revendications 5 et 6, **caractérisé en ce que** les zones de raccordement (22, 24) respectives peuvent être reliées entre elles par l'intermédiaire d'une liaison par complémentarité de formes et/ou à force.

8. Appareil de terrain électrique selon la revendication 7, **caractérisé en ce que** la liaison s'effectue dans la direction axiale par l'intermédiaire d'un vissage d'un appariement de trous des zones de raccordement respectives.

9. Appareil de terrain électrique selon l'une quelconque des revendications 5 à 7, **caractérisé en ce que** la zone de raccordement (22) est réalisée entre le premier et le deuxième module de telle sorte que la zone de raccordement du premier module peut être ajustée en continu.

10. Appareil de terrain électrique selon la revendication 9, **caractérisé en ce que** la zone de raccordement du deuxième module présente un motif de trou oblong.

11. Appareil de terrain électrique selon l'une quelconque des revendications 9 à 10, **caractérisé en ce que** le premier module (16) présente une butée de rotation par rapport au deuxième module (18).

12. Appareil de terrain électrique selon l'une quelconque des revendications précédentes, **caractérisé en ce que** le deuxième module (18) présente au moins une traversée de raccordement.

13. Appareil de terrain électrique selon l'une quelconque des revendications précédentes, **caractérisé en ce qu'**un système de détection de position pour une mesure de position d'une situation d'obturateur est disposé dans le premier module.

14. Appareil de terrain électrique selon l'une quelconque des revendications précédentes, **caractérisé en ce qu'**un convertisseur IP est disposé dans le premier module.

15. Vanne de processus d'une installation technique, comprenant une unité de vanne, qui présente une vanne de réglage ainsi qu'un entraînement qui est disposé dans un boîtier d'entraînement, dans lequel le boîtier d'entraînement est relié à un appareil de terrain électrique, qui sert à la commande et/ou régulation d'un actionneur de la vanne de réglage, **caractérisée en ce que** l'appareil de terrain électrique (10) est réalisé selon l'une quelconque des revendications précédentes.
